# EUROPÄISCHE PATENTSCHRIFT

(11) **EP 0 757 885 B1**
(45) Veröffentlichungstag und Bekanntmachung des Hinweises auf die Patenterteilung: **12.08.1998**
(21) Anmeldenummer: 95918584.4
(22) Anmeldetag: 21.04.1995
(51) Int. Cl.: H05K 3/40, H05K 3/06, H05K 3/34

(54) **VERFAHREN ZUR BILDUNG METALLISCHER LEITERMUSTER AUF ELEKTRISCH ISOLIERENDEN UNTERLAGEN**
METHOD OF FORMING METALLIC CONDUCTIVE PATTERNS ON INSULATING SUBSTRATES
PROCEDE DE FORMATION DE MOTIFS CONDUCTEURS METALLIQUES SUR DES SUBSTRATS ELECTRIQUEMENT ISOLANTS

(30) Priorität: 25.04.1994 DE 4414374
(43) Veröffentlichungstag der Anmeldung: 12.02.1997
(73) Patentinhaber: Siemens S.A., 1060 Bruxelles (BE)
(72) Erfinder: BOONE, Luc, B-8020 Oostkamp (BE); DE STEUR, Hubert, B-9810 Drongen (BE); DUMOULIN, Ann, B-8020 Oostkamp (BE); MATTELIN, Antoon, B-8020 Oostkamp (BE); VAN PUYMBROECK, Josef, B-8020 Oostkamp (BE); HEERMANN, Marcel, B-9200 Merelbeke (BE); SCHÖNBERGER, Eduard, D-92245 Kümmersbruck (DE)
(74) Vertreter: Epping, Wilhelm, Dr.-Ing.
(86) Internationale Anmeldenummer: EP9501514
(87) Internationale Veröffentlichungsnummer: WO9529573

(56) Entgegenhaltungen:
- EP-A- 0 095 256
- EP-A- 0 127 794
- EP-A- 0 370 133
- EP-A- 0 469 635

## Beschreibung

Aus der US-A-4 804 615 ist ein Verfahren zur Bildung metallischer Leitermuster mit lötbaren Anschlußbereichen bekannt, bei welchem von einer beidseitig kupferkaschierten, elektrisch isolierenden ebenen Unterlage ausgegangen wird. Nach dem Bohren von Durchkontaktierungslöchern wird in einem chemischen Abscheidungsbad eine Kupferschicht abgeschieden, die sich auch über die Lochwandungen erstreckt. Auf diese Kupferschicht wird dann ein Galvanoresist aufgebracht, welcher nur die späteren Anschlußbereiche nicht bedeckt, so daß hier nacheinander Kupfer und eine Zinn-Blei-Legierung galvanisch abgeschieden werden können. Die Zinn-Blei-Legierung bildet dabei eine lötbare Endoberfläche der Anschlußbereiche. Nach der vollständigen Entfernung des Galvanoresists wird ein Ätzresist aufgebracht, welcher mit Ausnahme der Anschlußbereiche sämtliche Bereiche des späteren Leitermusters bedeckt. Nachfolgend werden sämtliche, nicht dem Leitermuster entsprechenden Bereiche der chemisch abgeschiedenen Kupferschicht und der Kupferkaschierung bis zur Oberfläche der Unterlage abgeätzt. Bei diesem Ätzvorgang schützt nicht nur der eigentliche Ätzresist, sondern auch die atzresistente Endoberfläche der Anschlußbereiche das darunterliegende Kupfer vor einem Ätzangriff. Nach der vollständigen Entfernung des Ätzresists wird dann ein Lötstopplack aufgebracht, welcher nur die lötbaren Anschlußbereiche des Leitermusters nicht bedeckt.

Aus der US-A-4 608 274 ist ein weiteres Verfahren zur Bildung metallischer Leitermuster mit lötbaren Anschlußbereichen bekannt, bei welchem von einer vorgebohrten, elektrisch isolierenden ebenen Unterlage ausgegangen wird. Nach der stromlosen Abscheidung von Kupfer auf beiden Seiten der Unterlage und in den Löchern, wird auf die Kupferschicht ein Ätzresist aufgebracht, welcher mit Ausnahme der späteren Anschlußbereiche alle Bereiche des späteren Leiterbildes bedeckt. Anschließend wird ein Galvanoresist aufgebracht, welcher nur die späteren Anschlußbereiche nicht bedeckt, so daß hier nacheinander Kupfer und eine Zinn-Blei-Legierung galvanisch abgeschieden werden können. Nach der vollständigen Entfernung des Galvanoresists werden sämtliche Bereiche der freiliegenden Kupferschicht bis zur Oberfläche der Unterlage abgeätzt, wobei im Bereich des Leitermusters der Ätzresist und die ätzresistente Endoberfläche der Anschlußbereiche die darunterliegende Kupferschicht vor einem Ätzangriff schützen. Nach der vollstandigen Entfernung des Ätzresists wird dann auch hier wieder ein Lötstopplack aufgebracht, welcher nur die lötbaren Anschlußbereiche des Leitermusters nicht bedeckt.

Aus der DE-A-33 20 183 ist ein Verfahren bekannt, bei welchem zunächst auf ein beidseitig kupferkaschiertes und im Bereich von späteren Durchkontaktierungen mit Bohrungen versehenes Basismaterial ein photoempfindlicher Lack aufgebracht wird. Der positiv oder negativ arbeitende photoempfindliche Lack wird dabei beispielsweise mittels Siebdruck so aufgebracht, daß die die Bohrungen umgebenden Anschlußbereiche frei bleiben. Beim galvanischen Abscheiden von Kupfer und Zinn oder einer Zinn-Blei-Legierung auf den Anschlußbereichen und den Bohrungswandungen, dient der photoempfindliche Lack als Galvanoresist. Nach einer Photostrukturierung dient der Lack dann beim Ätzen des Leiterbildes als Ätzresist. Da der Lack nach dem Ätzvorgang nicht von den Leiterbahnen entfernt wird, kann er beim späteren Lötvorgang auch als Lötstopplack ausgenutzt werden.

Bei dem aus der US-A-4 804 615 bekannten Verfahren werden der Galvanoresist und der Ätzresist durch Belichten und Entwikkeln eines positiv oder negativ arbeitenden, photoempfindlichen Resistmaterials hergestellt, während bei dem aus der US-A-4 608 274 bekannten Verfahren Galvanoresist und Ätzresist durch Siebdrucken aufgebracht werden. Der Lötstopplack wird in beiden Fällen selektiv so aufgetragen, daß die lötbaren Anschlußbereiche frei bleiben. Das ganzflächige Auftragen eines photoempfindlichen Lötstopplackes mit anschließender Strukturierung durch Belichten und Entwickeln ist jedoch ebenfalls möglich.

Bei der Bildung metallischer Leitermuster auf dreidimensionalen elektrisch isolierenden Unterlagen, bereitet die Strukturierung von Galvanoresists, Ätzresists und Lötstopplacken Schwierigkeiten, da hier eine Photostrukturierung mit herkömmlichen Maskentechniken oder eine Strukturierung mittels Siebdruck nicht anwendbar sind. Bei der Herstellung von Leitermustern auf dreidimensionalen Unterlagen, die häufig auch als dreidimensionale Leiterplatten oder als Spritzgießteile mit integrierten Leiterzügen bezeichnet werden, wird daher bevorzugt eine Strukturierung von Galvanoresist, Ätzresist oder Lötstopplack mittels Laserstrahlung eingesetzt. So ist es beispielsweise aus der EP-A-0 469 635 bekannt, auf eine dreidimensionale, elektrisch isolierende Unterlage eine Metallisierung und einen organischen Ätzresist aufzubringen, worauf dieser Ätzresist in den unmittelbar an das spätere Leitermuster angrenzenden Bereichen mittels Laserstrahlung entfernt, und die dadurch freigelegte Metallisierung weggeätzt wird. Die Konturbeschreibung mittels Laserstrahlung ist dabei als eine enge Umfahrung des Leitermusters anzusehen, die im Hinblick auf die geringe Flachenausdehnung des abzutragenden Ätzresists rasch vorgenommen werden kann. Vom Leitermuster mechanisch und elektrisch durch Ätzgräben getrennte Inselbereiche der Metallisierung können ohne eigentliche Funktion stehen bleiben oder auch an Masse oder ein einheitliches Potentail gelegt werden und die Funktion von Abschirmungen übernehmen. Das Aufbringen des organischen Ätzresists durch die Metallisierung kann beispielsweise durch Elektrotauchlackierung oder durch elektrostatische Beschichtung vorgenommen werden.

Der im Anspruch 1 angegebenen Erfindung liegt das Problem zugrunde, ein einfaches und wirtschaftliches Verfahren zur Bildung metallischer Leitermuster mit löt- und/oder bondbaren Anschlußbereichen auf elektrisch isolierenden Unterlagen zu schaffen, das sowohl für die Herstellung konventioneller Leiterplatten, als auch für die Herstellung von dreidimensionalen Spritzgießteilen mit integrierten Leiterzügen geeignet ist.

Die mit der Erfindung erzielten Vorteile bestehen insbesondere darin, daß nur eine einzige organische Schutzschicht in einem Elektrotauchbad aufgebracht werden muß, die nach einer ersten Strukturierung mittels Laserstrahlung als Galvanoresist und nach einer zweiten Strukturierung mittels Laserstrahlung als Ätzresist dient und auch nach der Bildung des Leitermusters nicht entfernt werden muß. Hierdurch ergibt sich eine deutliche Vereinfachung und Verkürzung des gesamten Herstellungsprozesses. Das einfache, wirtschaftlich und rasche Aufbringen der Schutzschicht in einem Elektrotauchbad und die Laserstrukturierungen der Schutzschicht vor deren Anwendung als Galvanoresist und als Ätzresist, bereiten auch bei dreidimensionalen Unterlagen keine Schwierigkeiten.

Vorteilhafte Ausgestaltungen der Erfindung sind in den Ansprüchen 2 bis 13 angegeben.

Gemäß Anspruch 2 kann die Erfindung bevorzugt bei dreidimensionalen, durch Spritzgießen einer thermoplastischen Formmasse hergestellten Unterlagen angewandt werden.

Die Ausgestaltung nach Anspruch 3 ermöglicht eine einfache und insbesondere auch für dreidimensionale Unterlagen geeignete Herstellung der Metallisierung durch chemische und nachfolgende galvanische Metallabscheidung, wobei gemaß Anspruch 4 eine insgesamt aus Kupfer bestehende Metallisierung bevorzugt wird.

Das ganzflächige Aufbringen der Metallisierung auf die Unterlage gemäß Anspruch 5 kann ohne Maßnahmen zur partiellen Abdeckung oder dergleichen auf besonders einfache Weise durchgeführt werden.

Die Weiterbildung nach Anspruch 6 bietet die Möglichkeit, die zuvor bereits als Galvanoresist und Ätzresist eingesetzte Schutzschicht zusätzlich auch noch als Lötstoppmaske zu verwenden.

Die Ausgestaltung nach Anspruch 7 erhöht die Beständigkeit der Schutzschicht gegenüber galvanischen Metallabscheidungsbädern und gegenüber Ätzmitteln. Gemäß Anspruch 8 kann diese Schutzschicht dann nach dem Ätzvorgang vollständig ausgehärtet werden, wodurch die Temperaturbeständigkeit und damit die Eignung als Lötstoppmaske erheblich verbessert wird.

Gemäß Anspruch 9 wird vorzugsweise als Schutzschicht ein einfacher, nicht photoempfindlicher Lack verwendet, zumal derartige Lacke eine mehrfache Laserstrukturierung zulassen. Die Verwendung eines gefärbten Lackes nach Anspruch 10 erleichtert durch die erhöhte Absorption dessen partielle Entfernung mittels Laserstrahlung.

Die Ausgestaltungen nach den Ansprüchen 11 und 12 geben bewährte Materialien für die Bildung lötfähiger bzw. bondfähiger Endoberflächen durch galvanische Metallabscheidung an.

Die Weiterbildung nach Anspruch 13 bietet schließlich die Möglichkeit, die Flanken des Leitermusters auf einfache Weise zuverlässig vor Korrosion zu schützen.

Ein Ausführungbeispiel der Erfindung ist in der Zeichnung dargestellt und wird im folgenden näher beschrieben.

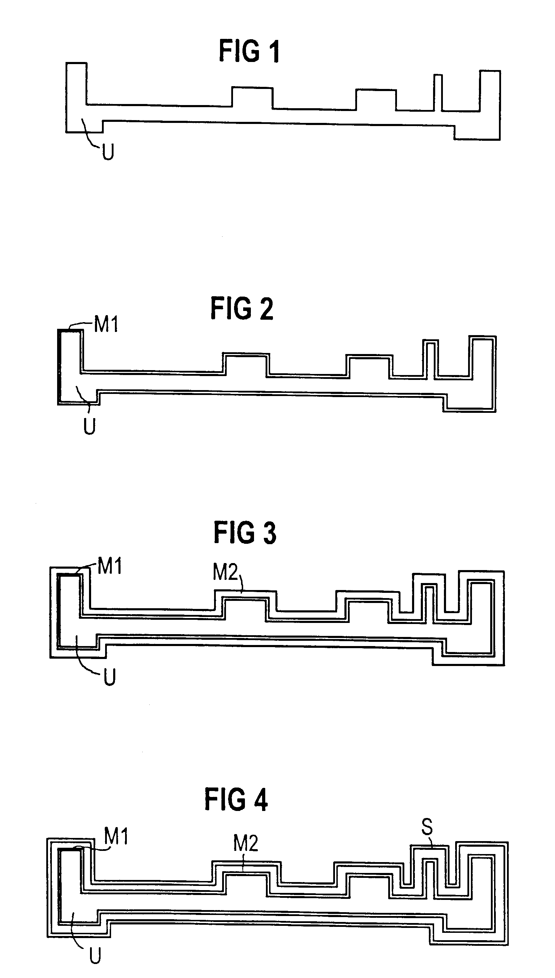

Die Figuren 1 bis 8 zeigen in stark vereinfachter schematischer Darstellung die verschiedenen Verfahrensstadien bei der Bildung metallischer Leitermuste mit lötbaren Anschlußbereichen auf dreidimensionalen, elektrisch isolierenden Unterlagen.

Gemäß Figur 1 wird von einer stark strukturierten, schachtelförmigen Unterlage U ausgegangen, die beispielsweise durch Spritzgießen in großer Anzahl wirtschaftlich hergestellt werden kann. Im geschilderten Ausführungsbeispiel besteht die Unterlage U aus glasfaserverstärktem Polyetherimid.

Die in Figur 1 dargestelle Unterlage U wird zunächst zur Erhöhung der Haftfestigkeit des später aufzubringenden Leitermusters angeätzt und anschließend gereinigt. Nach der Reinigung erfolgt eine aus der Zeichnung nicht näher erkennbare Bekeimung der Unterlage U, z.B. durch Eintauchen in ein Pd-Cl₂-SnCl₂-Bad.

Nach einer Aktivierung der Bekeimung wird ganzflächig eine Metallisierung auf die Unterlage U aufgebracht, wobei sich diese Metallisierung aus einer in Figur 2 dargestellten ersten Metallisierungsschicht M1 und einer aus Figur 3 ersichtlichen zweiten Metallisierungsschicht M2 zusammensetzt. Die erste Metallisierungsschicht M1 wird dabei durch außenstromlose chemische Kupferabscheidung auf die Unterlage U aufgebracht, während die Metallisierungsschicht M2 durch galvanische Kupferabscheidung erzeugt wird. Die aus den Schichten M1 und M2 bestehende Metallisierung weist beispielsweise eine Stärke von insgesamt 30µm auf.

Gemäß Figur 4 wird dann auf die zweite Metallisierungsschicht M2 durch Elektrotauchlackierung eine organische Schutzschicht S1 ganzflachig aufgebracht und anschließend in einem Umluftofen getrocknet, wobei die Temperatur so gewählt wird, daß sich eine Anhartung, aber keine vollständige Aushärtung ergibt. Für die Bildung,der Schutzschicht S wird dabei ein nicht photoempfindlicher, beispielsweise grau oder schwarz gefärbter Elektrotauchlack eingesetzt. Derartige Elektrotauchlacke werden beispielsweise für die Lackierung von Karosserien in der Automobilindustrie eingesetzt. Im beschriebenen Ausführungsbeispiel wurden Acrylat- oder Epoxy-Lacke verwendet, wie sie von der AKZO COATINGS S.A. 60762 Montataire Cedex (FR) unter dem Handelsnamen Cortek ED-C-5000 oder 6000 vertrieben werden.

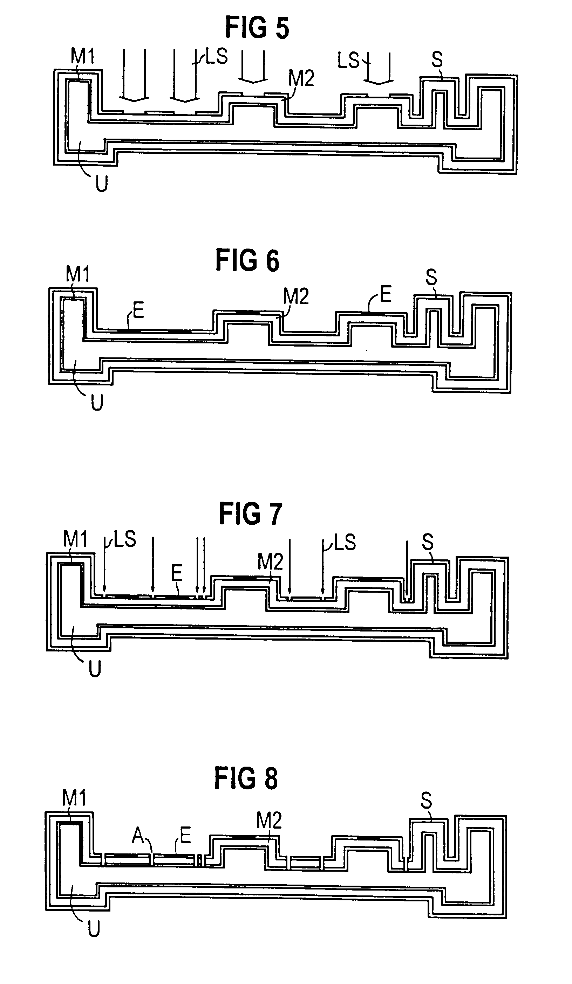

Gemäß Figur 5 wird die organische Schutzschicht S dann mit Hilfe eines Nd-YAG-Lasers in einem Scanverfahren strukturiert, wobei die Laserstrahlung durch Pfeile LS angedeutet ist. Die Entfernung der Schutzschicht S ist dabei auf die späteren Anschlußbereiche begrenzt.

Nach der geschilderten selektiven Entfernung der Schutzschicht S in den späteren Anschlußbereichen wird auf die dadurch freigelegten Bereiche der zweiten Metallisierungsschicht M2 gemäß Figur 6 durch galvanische Metallabscheidung eine atzresistente Endoberfläche E aufgebracht. Im geschilderten Ausführungsbeispiel wird diese Endoberfläche E durch galvanische Abscheidung einer Zinn-Blei-Legierung hergestellt.

Gemäß Figur 7 wird die organische Schutzschicht S dann nochmals mittels Laserstrahlung LS strukturiert, wobei bei dieser Laserstrukturierung die Entfernung der Schutzschicht S auf die unmittelbar an das spätere Leitermuster angrenzenden Bereiche beschränkt ist. Die Konturbeschreibung mittels Laserstrahlung LS ist hier also als eine enge Umfahrung des Leitermusters anzusehen. Die Umfahrung des Leitermusters mit einer einfachen oder eine doppelten Laserspur reicht dabei bereits aus.

Nach der aus Figur 7 ersichtlichen selektiven Entfernung der Schutzschicht S werden die hierdurch freigelegten Bereiche der aus der ersten Metallisierungsschicht M1 und der zweiten Metallisierungsschicht M2 zusammengesetzten Metallisierung durch Ätzen entfernt, wobei hierfür in der Subraktivtechnik übliche Ätzlösungen eingesetzt werden können. Aus Figur 8 ist ersichtlich, daß bei diesem Vorgang Ätzgräben A entstehen, welche.einerseits das Leitermuster aus der Metallisierung M1, M2 herausbilden und von den beispielsweise seitlich und unten stehenbleibenden Inselbereichen der Metallisierung elektrisch und mechanisch trennen. Die nach den beiden Laserstrukturierungen verbliebene Schutzschicht S wird nicht entfernt, da sie nach einer vollständigen Aushärtung sämtliche an einen Lötstopplack gestellten Erfordernisse erfüllt. Das Aushärten der Schutzschicht S wird hierbei wieder in einem Umluftofen vorgenommen.

Die Schutzschicht S läßt nur in den Anschlußbereichen die Endoberfläche E frei. Einsatzbereite lötfahige Anschlußflächen können dann beispielsweise durch Heißverzinnen oder durch einen Umschmelzvorgang erzeugt werden. Ein Eindringen von Lot im Bereich der Ätzgräben A ist dabei im Hinblick auf deren geringe Breite von beispielsweise 150µm im Falle einer einfachen Laserspur nicht zu befürchten.

Die im Bereich der Ätzgräben freiliegenden Flanken der Metallisierung M1, M2 können jedoch im einem letzten Verfahrensschritt durch stromlose Abscheidung von Zinn, Gold oder Nikkel vor Korossion geschützt werden. Aus der Zeichnung ist ein derartiger Flankenschutz jedoch nicht ersichtlich.

Das vorstehend beschriebene Prinzip einer Verwendung der gleichen Schutzschicht S als Galvanoresist, als Ätzresist und als Lötstopplack, kann auch dann realisiert werden, wenn von vorneherein ein handelsüblicher Lötstopplack als Schutzschicht S auf die Metallisierung M1, M2 aufgebracht wird. So kann beispielsweise durch Vorhanggießen ein unter dem Handelsnamen PROBIMER 52 von der CIBA GEIGY AG, Basel (CH) vertriebener, positiv arbeitetender photoempfindlicher Lötstopplack verwendet werden und auf die beschriebene Weise mittels Laserstrahlung strukturiert werden. Neben nicht photoempfindlichen Lacken und positiv arbeitenden photoempfindlichen Lacken können sogar auch negativ arbeitende photoempfindliche Lacke eingesetzt werden. In diesem Fall müßte jedoch die erste Strukturierung als herkömmliche Photostrukturierung durchgeführt werden und die zweite Strukturierung mittels Laserstrahlung vorgenommen werden.

Abweichend von dem vorstehend beschriebenen Ausführungsbeispiel kann auch eine bondbare Endoberfläche E der Anschlußbereiche hergestellt werden. Hierzu werden anstelle einer Zinn-Blei-Legierung beispielsweise nacheinander Nickel und Gold galvanisch abgeschieden.

## Patentansprüche

1. Verfahren zur Bildung metallischer Leitermuster mit lötund/oder bondbaren Anschlußbereichen auf elektrisch isolierenden Unterlagen (U), mit folgenden Verfahrensschritten:
a) Aufbringen einer Metallisierung (M1,M2) auf die Unterlage (U);
b) Aufbringen einer organischen, galvano- und ätzresistenten Schutzschicht (S) auf die Metallisierung (M1,M2) in einem Elektrotauchbad;
c) Entfernen der Schutzschicht (S) in den späteren Anschlußbereichen mittels Laserstrahlung (LS);
d) Galvanische Abscheidung einer atzresistenten, lötund/oder bondbaren Endoberfläche (E) auf die im Verfahrensschritt c) freigelegten Bereiche der Metallisierung (M1,M2);
e) Entfernen der Schutzschicht (S) zumindest in den unmittelbar an das spätere Leitermuster angrenzenden Bereichen mittels Laserstrahlung (LS);
f) Abätzen der im Verfahrensschritt e) freigelegten Bereiche der Metallisierung (M1,M2) bis zur Oberfläche der Unterlage (U).

2. Verfahren nach Anspruch 1,
**dadurch gekennzeichnet,**
daß eine dreidimensionale, durch Spritzgießen einer thermoplastischen Formmasse hergestellte Unterlage (U) verwendet wird.

3. Verfahren nach Anspruch 1 oder 2,
**dadurch gekennzeichnet,**
daß die Metallisierung (M1,M2) durch chemische Abscheidung einer ersten Metallisierungsschicht (M1) und nachfolgende galvanische Abscheidung einer zweiten Metallisierungsschicht (M2) auf die Unterlage (U) aufgebracht wird.

4. Verfahren nach Anspruch 3,
**dadurch gekennzeichnet,**
daß die Metallisierung (M1,M2) durch die chemische und nachfolgend galvanische Abscheidung von Kupfer auf die Unterlage (U) aufgebracht wird.

5. Verfahren nach einem der vorhergehenen Ansprüche,
**dadurch gekennzeichnet,**
daß die Metallisierung (M1,M2) ganzflachig auf die Unterlage (U) aufgebracht wird.

6. Verfahren nach einem der vorhergehenen Ansprüche,
**dadurch gekennzeichnet,**
daß in dem Elektrotauchbad als Schutzschicht (S) ein temperaturbeständiger, als Lötstopplack geeigneter Lack auf die Metallisierung (M1,M2) aufgebracht wird.

7. Verfahren nach einem der vorhergehenen Ansprüche,
**dadurch gekennzeichnet,**
daß die Schutzschicht (S) nach dem Aufbringen auf die Metallisierung (M1,M2) getrocknet wird.

8. Verfahren nach einem der vorhergehenen Ansprüche,
**dadurch gekennzeichnet,**
daß die nach dem Verfahrensschritt e) verbliebene Schutzschicht (S) ausgehärtet wird.

9. Verfahren nach einem der vorhergehenden Ansprüche,
**dadurch gekennzeichnet,**
daß in dem Elektrotauchbad als Schutzschicht (S) ein nicht photoempfindlicher Lack auf die Metallisierung (M1,M2) aufgebracht wird.

10. Verfahren nach Anspruch 9,
**gekennzeichnet durch**
die Verwendung eines zur Erhöhung der Absorption der Laserstrahlung (LS) gefärbten Lackes.

11. Verfahren nach einem der vorhergehenden Ansprüche,
**dadurch gekennzeichnet,**
daß im Verfahrensschritt d) als Endoberfläche (E) Zinn oder eine Zinn-Blei-Legierung abgeschieden wird.

12. Verfahren nach einem der Ansprüche 1 bis 10,
**dadurch gekennzeichnet,**
daß im Verfahrensschritt d) als Endoberfläche Nickel und Gold abgeschieden werden.

13. Verfahren nach einem der vorhergehenden Ansprüche,
**dadurch gekennzeichnet,**
daß nach dem Verfahrensschritt f) auf die Flanken des Leitermusters durch chemische Metallabscheidung ein Korrosionsschutz aufgebracht wird.

## Claims

1. Method for forming a metallic conductor pattern with solderable and/or bondable connection regions on electrically insulating substrates (U), having the following procedural steps:
a) applying a metallization (M1, M2) to the substrate (U);
b) applying an organic protective layer (S), which resists electrolysis and etching, to the metallization (M1, M2) in an electrolytic dip-coating bath;
c) removing the protective layer (S) in the future connection regions using laser radiation (LS);
d) electrolytically depositing an etching-resistant, solderable and/or bondable end surface (E) to the regions of the metallization (M1, M2) which were exposed in procedural step c);
e) removing the protective layer (S) at least in the regions directly adjoining the future conductor pattern using laser radiation (LS);
f) etching the regions of the metallization (M1, M2) which were exposed in procedural step e) down to the surface of the substrate (U).

2. Method according to Claim 1, characterized in that use is made of a three-dimensional substrate (U) produced by injection-moulding a thermoplastic moulding material.

3. Method according to Claim 1 or 2, characterized in that the metallization (M1, M2) is applied to the substrate (U) by chemical deposition of a first metallization layer (M1) and subsequent electrolytic deposition of a second metallization layer (M2).

4. Method according to Claim 3, characterized in that the metallization (M1, M2) is applied to the substrate (U) by the chemical and subsequently electrolytic deposition of copper.

5. Method according to one of the preceding claims, characterized in that the metallization (M1, M2) is applied surface-wide to the substrate (U).

6. Method according to one of the preceding claims, characterized in that a thermally stable coating, suitable as a solder-stop coating, is applied to the metallization (M1, M2) as a protective layer (S) in the electrolytic dip-coating bath.

7. Method according to one of the preceding claims, characterized in that the protective layer (S) is dried after application to the metallization (M1, M2).

8. Method according to one of the preceding claims, characterized in that the protective layer (S) remaining after procedural step e) is cured.

9. Method according to one of the preceding claims, characterized in that a non-photosensitive coating is applied to the metallization (M1, M2) as a protective layer (S) in the electrolytic dip-coating bath.

10. Method according to Claim 9, characterized by the use of a coating which is coloured in order to increase the absorption of the laser radiation (LS).

11. Method according to one of the preceding claims, characterized in that tin or a tin/lead alloy is deposited in procedural step d) as the end surface (E).

12. Method according to one of Claims 1 to 10, characterized in that nickel and gold are deposited in procedural step d) as the end surface.

13. Method according to one of the preceding claims, characterized in that, after procedural step f), corrosion protection is applied to the sides of the conductor pattern by chemical metal deposition.

## Revendications

1. Procédé de formation de motifs conducteurs métalliques présentant des zones de connexion soudables et/ou connectables sur des substrats électriquement isolants (U), ledit procédé comprenant les étapes suivantes :
a) dépôt d'une métallisation (M1, M2) sur le substrat (U) ;
b) dépôt d'une couche protectrice (S) organique, galvano-résistante et résistante à l'attaque chimique sur la métallisation (M1, M2), dans un bain d'électrophorèse ;
c) élimination de la couche protectrice (S) dans les futures zones de connexion au moyen d'un rayonnement laser (LS);
d) déposition par électrolyse d'une surface d'extrémité résistante à l'attaque chimique soudable et/ou connectable (E) sur les zones de la métallisation (M1, M2) dégagées au cours de l'étape c);
e) élimination de la couche protectrice (S) au moins dans les zones immédiatement adjacentes du futur motif conducteur au moyen d'un rayonnement laser (LS) ;
f) attaque chimique des zones de la métallisation (M1, M2) dégagées au cours de l'étape e), jusqu'à la surface du substrat (U).

2. Procédé selon la revendication 1,
caractérisé en ce que
on utilise un substrat (U) en trois dimensions, fabriqué par moulage par injection à partir d'une matière à mouler thermoplastique.

3. Procédé selon la revendication 1 ou 2,
caractérisé en ce que
la métallisation (M1, M2) est appliquée par dépôt chimique d'une première couche de métallisation (M1), puis par déposition par électrolyse d'une seconde couche de métallisation (M2) sur le substrat (U).

4. Procédé selon la revendication 3,
caractérisé en ce que
la métallisation (M1, M2) est appliquée par dépôt chimique, puis par dépôt par électrolyse de cuivre sur le substrat (U).

5. Procédé selon l'une des revendications précédentes,
caractérisé en ce que
la métallisation (M1, M2) est réalisée sur toute la surface du substrat (U).

6. Procédé selon l'une des revendications précédentes,
caractérisé en ce que
l'on applique comme couche protectrice (S) sur la métallisation (M1, M2), dans le bain d'électrophorèse, un vernis thermorésistant, approprié en tant que réserve de soudure.

7. Procédé selon l'une des revendications précédentes,
caractérisé en ce que
la couche protectrice (S) est séchée après application sur la métallisation (M1, M2).

8. Procédé selon l'une des revendications précédentes,
caractérisé en ce que
la couche protectrice (S) restant après l'étape de procédé e) est durcie.

9. Procédé selon l'une des revendications précédentes,
caractérisé en ce que
l'on applique sur la métallisation (M1, M2) comme couche protectrice, dans le bain d'électrophorèse, un vernis non photosensible.

10. Procédé selon la revendication 9,
caractérisé par
l'utilisation d'un vernis coloré pour augmenter l'absorption du rayonnement laser (LS).

11. Procédé selon l'une des revendications précédentes,
caractérisé en ce que
au cours de l'étape de procédé d), de l'étain ou un alliage étain-plomb est déposé en tant que surface d'extrémité (E).

12. Procédé selon l'une des revendications 1 à 10,
caractérisé en ce que
au cours de l'étape de procédé d), du nickel et de l'or sont déposés en tant que surface d'extrémité (E).

13. Procédé selon l'une des revendications précédentes,
caractérisé en ce que
après l'étape de procédé f), on applique une protection vis-à-vis d'une attaque chimique sur les flancs du motif conducteur, par déposition chimique de métaux.
